# EUROPÄISCHE PATENTSCHRIFT

(11) **EP 2 653 850 B1**
(45) Veröffentlichungstag und Bekanntmachung des Hinweises auf die Patenterteilung: **14.01.2015**
(21) Anmeldenummer: 12164600.4
(22) Anmeldetag: 18.04.2012
(51) Int. Cl.: G01M 17/007, G01R 31/00

(54) **Verfahren und IT-System zum Durchführen von Gesamtfahrzeugtests**
Method and IT system for testing entire vehicles
Procédé et système informatique destinés à l'exécution de tests complets de véhicule automobile

(43) Veröffentlichungstag der Anmeldung: 23.10.2013
(73) Patentinhaber: Siemens Aktiengesellschaft, 80333 München (DE)
(72) Erfinder: Feld, Joachim, 90451 Nürnberg (DE)

(56) Entgegenhaltungen:
- US-A1- 2007 150 254
- US-A1- 2008 312 889
- US-A1- 2009 306 952

## Beschreibung

Die Erfindung betrifft ein Verfahren und ein IT-System zum Durchführen von Gesamtfahrzeugtests.

Die US 2007/150254 A1 beschreibt eine Modellierungsumgebung zur Simulation von Fahrzeugen. Hierbei ist ein Simulationskoordinationsmodul vorgesehen, das mit einer Vielzahl von Simulationsmodulen kommuniziert. Jedes der Simulationsmodule kann dazu konfiguriert werden, das Betriebsverhalten von wenigstens einer herzustellenden Komponente eines Fahrzeugs zu modellieren. Das Simulationskoordinationsmodul kann dazu konfiguriert sein, Prozesse, die dem Betrieb der Vielzahl von Simulationsmodulen zugeordnet sind, auf mehrere Prozessoren einer Simulationsmaschine zu verteilen.

Die US 2008/312889 A1 beschreibt ein System zum Testen einer Steuerungseinheit eines Fahrzeugs. Hierzu wird ein Emulator zum Emulieren eines Sensors vorgeschlagen.

Die US 2009/306952 A1 beschreibt ein System mit einem Bus zum Simulieren eines Geräts, das mittels einer Vielzahl von Steuerungseinheit gesteuert wird.

In heutigen Automobilen sind die unterschiedlichen Steuerungsfunktionen über viele verschiedene elektronische Steuergeräte verteilt. Manche Personenkraftwagen umfassen bis zu achtzig unterschiedliche Steuergeräte. Jedes Steuergerät hat einen Busanschluss, über den es von mindestens einem anderen Steuergerät aus erreicht werden kann. Mehrere dieser Bussysteme (die beispielsweise zehn oder mehr einzelne Bussegmente umfassen) sind miteinander über Gateways vernetzt.

Um eine gesamte Fahrzeugfunktionalität zu simulieren, ist es notwendig, alle diese Steuergeräte einzeln in der Simulationsumgebung auszuprägen und auch einzeln unabhängig voneinander zu simulieren. Die zwischen den Steuergeräten liegenden Bussysteme sind dabei ebenfalls mit einzubeziehen, da deren nichtdeterministisches Verhalten entscheidend für die Gesamtfunktionalität ist. Solche Simulationssysteme sind derzeit am Markt so gut wie nicht erhältlich.

Bisher wurden durch SIL-Prüfstände (SIL = Software-in-the-loop) oder HIL-Prüfstände (HIL = Hardware-in-the-loop) Prüfstände einzelne Softwarestände (SIL) oder Hardwarebaugruppen (HIL) getestet. Dabei wurde mittels des Prüfstands, in den die Software oder Hardware eingebunden wird der Rest des Fahrzeugs (soweit notwendig) simuliert. Solche Tests geben eine Aussage über einzelne zu testende Funktionen, nicht jedoch über das gesamte Fahrzeug. Das ist auch nicht das Ziel eines solchen Tests.

Eine Gesamtfahrzeugintegration kann erst dann erfolgen, wenn alle Zulieferer reale Hardwarebaugruppen beigestellt haben und diese in einem gemeinsamen Integrationstest (meistens beim Fahrzeughersteller) zum Laufen gebracht worden sind. Das führt erfahrungsgemäß zu sehr zeitintensiven Hochlaufzeiten, in denen zuerst Abstimmungsprobleme zwischen den Geräten gelöst werden müssen, bevor man zu den eigentlichen Funktionstests kommt.

Für eine vergleichbare Vorgehensweise ohne Zentralrechner müsste jeder Zulieferer bei beispielsweise 80 Steuergeräten je Fahrzeug (zusätzlich zu den für seine eigenen Zwecke benötigten Hardwarekomponenten) noch einmal 80 Steuergeräte für andere Zulieferer bereitstellen. Abgesehen von den hohen Kosten für solche (oftmals einzeln hergestellten) Muster sind auch Aufwände für Versionsverwaltung, Rückführung nicht mehr benötigter Baugruppen usw. zu berücksichtigen. Besonders nachteilig ist der Zeitbedarf für die Bereitstellung der Testhardware, weil er die Innovationsgeschwindigkeit bremst.

Der Aufgabe der vorliegenden Erfindung besteht darin, ein Verfahren bereitzustellen, mit dem Vorbereitungszeiten für Integrationstest verkürzt werden können.

Erfindungsgemäß wird diese Aufgabe gelöst durch ein Verfahren zum Durchführen von Gesamtfahrzeugtests, das folgende Schritte umfasst:
- Bereitstellen eines Zentralrechners mit einer Koordinationssoftware, wobei der Zentralrechner ein oder mehrere Fahrzeugbussysteme umfasst und der Zentralrechner ein auf mindestens zwei Entwicklungsstandorte verteiltes Rechnersystem ist und mindestens eines der Fahrzeugbussysteme des Zentralrechners eine Datenverbindung zwischen den mindestens zwei Entwicklungsstandorten nutzt;
- Laden von Steuergerätesoftware einer Vielzahl von Steuergeräten in den Zentralrechner;
- gleichzeitiges oder quasigleichzeitiges Ausführen der Steuergerätesoftware der Vielzahl von Steuergeräten unter der Koordinationssoftware und Erfassen von Testdaten, wobei die Koordinationssoftware eine Simulationssoftware umfassen, die Echtzeitumgebungen der Steuergeräte simuliert; und
- Auswerten der Testdaten.

Darüber hinaus wird die erfindungsgemäße Aufgabe durch ein IT-System zum Durchführen von Gesamtfahrzeugtests gelöst, das dazu vorbereitet ist, das erfindungsgemäße Verfahren durchzuführen.

Durch Nutzung der Zentralarchitektur kann der Integrationstestaufwand vieler einzelner kleiner Hardwarebaugruppen verringert werden. Insbesondere kann eine Vorbereitungszeit für Gesamttests verkürzt werden und eine Innovationsgeschwindigkeit beschleunigt werden. Durch die Einführung eines zentralen Steuergeräts, auf welchem (in Gestalt von Softwarekomponenten) Funktionen unterschiedlicher Steuergeräte zusammengefasst sind, kann eine einfache Simulationsumgebung aufgebaut werden. Software-Simulationssysteme für große Zentralrechnerarchitekturen sind seit langem in ausreichender Qualität auf dem Markt erhältlich.

Auf entsprechend leistungsfähigen Entwicklungsrechnern kann anstelle oder zusätzlich zu einer Simulationsumgebung auch eine reale Laufzeitumgebung verwendet werden. Durch deren deutlich vergrößerte Ressourcen (insbesondere des Arbeitsspeichers) können mit entsprechenden Tracesystemen verhältnismäßig einfach komplexe Fehlerszenarien eingespielt und nachgestellt werden.

Anwendungsvorteile der erfindungsgemäßen Lösung werden im Anschluss an die Figurenbeschreibung näher erläutert.

Der Zentralrechner umfasst ein oder mehrere Fahrzeugbussysteme. Hiermit kann das Verhalten des Fahrzeugnetzes realitätsnäher als ohne Fahrzeugbussysteme simuliert werden.

Der Zentralrechner ist als ein auf mindestens zwei Entwicklungsstandorte verteiltes Rechnersystem ausgebildet, wobei mindestens eines der Fahrzeugbussysteme des Zentralrechners eine Datenverbindung zwischen den mindestens zwei Entwicklungsstandorten nutzt. Hierdurch ist es möglich, ohne Umzug Entwicklungsressourcen für Gesamttests zusammenzuführen.

Auch kann es von Vorteil sein, wenn der Zentralrechner ein oder mehrere Entwicklungsrechner für die Steuergeräte umfasst. Hierdurch kann geeignete, erprobte Hardware für die Tests genutzt werden.

Eine weitere zweckmäßige Weiterbildung sieht vor, dass die Koordinationssoftware dazu vorbereitet ist, ein oder mehrere Fahrzeugbussysteme zu simulieren. Hierdurch können bei den Testaufbauten aufwändige Hardwareschnittstellen zu Fahrzeugbussystemen eingespart werden.

Außerdem ist es möglich, dass die Koordinationssoftware ein Betriebssystem für den Zentralrechner umfasst. Hierdurch können auf dem Zentralrechner Simulations- und/oder Fahrzeugprogramme in erprobter Weise ausgeführt werden.

Eine bevorzugte Weiterbildung sieht vor, dass die Simulationssoftware unter einem Betriebssystem für den Zentralrechner lauffähig ist. Hiermit kann eine erprobte Umgebung für Simulationssoftware bereitgestellt werden und eine Hardwareabhängigkeit der Simulationssoftware verringert werden.

Besonders realitätsnahe Tests sind möglich, wenn die Steuergerätesoftware auf dem Zentralrechner in Echtzeitgeschwindigkeit durchgeführt wird. Hierdurch können Tests durchgeführt werden, die insbesondere dann realitätsnäher sind, wenn ein dynamisches Verhalten einer Fahrzeugkomponente im Zusammenspiel mit den Steuergeräten zu beurteilen ist, und es können hiermit Testzeiten verringert werden.

Die Erfindung ist anhand der beigefügten Zeichnungen näher erläutert, in denen zeigen:
- FIG 1: schematisch ein Fahrzeugnetzwerk zur Durchführung von Gesamtfahrzeugtests,
- FIG 2: schematisch eine Softwarestruktur im Zentralrechner und
- FIG 3: ein Ablaufdiagramm für ein Verfahren zum Durchführen von Gesamtfahrzeugtests.

Die nachfolgend näher geschilderten Ausführungsbeispiele stellen bevorzugte Ausführungsformen der vorliegenden Erfindung dar.

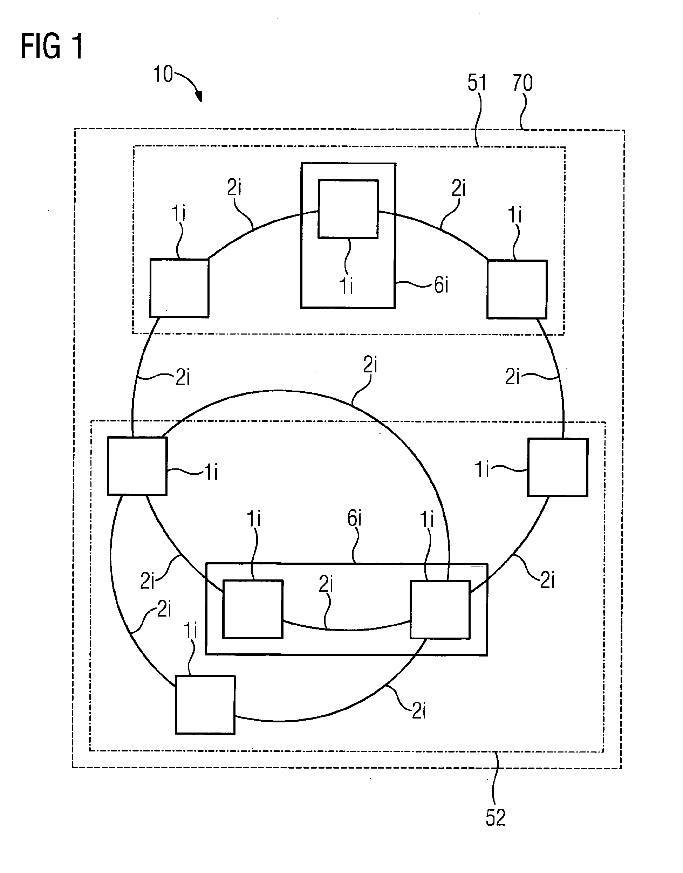

Die FIG 1 zeigt ein Ausführungsbeispiel eines auf einem Zentralrechner 70 konfigurierten Abbilds eines Fahrzeugnetzes 10 (Fahrzeugnetzwerks), das mehrere Steuergeräte 1i umfasst, sowie Übertragungsstrecken 2i zwischen den Steuergeräten 1i. In Realität (also wenn es nicht simuliert wird) ist das Fahrzeugnetz 10 zur Durchführung einer Vielzahl von Steuerungs- und Überwachungsaufgaben in einem Fahrzeug vorgesehen.

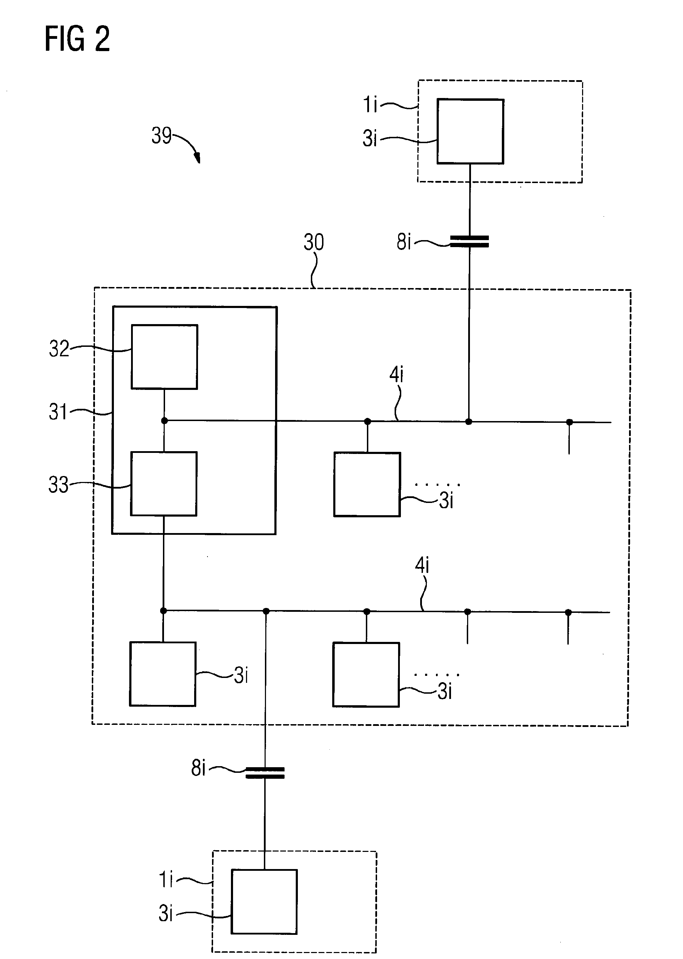

Die in FIG 2 gezeigte Softwarestruktur 39 kann als Softwarehierarchie verstanden werden. Die Figur enthält keine Aussage darüber, an welchem Standort 51, 52 oder auf welcher Rechnerhardware, welchem Server oder welchem Entwicklungsrechner 6i die Software 32, 33, 3i, 4i gehalten wird und ausgeführt wird. Der Zentralrechner 30 kann ein Rechnersystem sein, das auf zwei oder mehr Entwicklungsstandorte 51, 52 verteilt ist. Mindestens eines der Fahrzeugbussysteme 4i des Zentralrechners 30 kann eine Datenverbindung 2i zwischen zwei Entwicklungsstandorten 51, 52 nutzen. Eine vorteilhafte Option sieht vor, dass der Zentralrechner 30 ein oder mehrere Entwicklungsrechner 6i für die Steuergeräte 2i umfasst. Es kann auch zweckmäßig sein, die Koordinationssoftware 31 dazu vorzubereiten, ein oder mehrere Fahrzeugbussysteme 4i zu simulieren.

Die Simulationssoftware 33 ist typischerweise unter dem Betriebssystem 32 für den Zentralrechner 30 lauffähig. Das Betriebssystem 32 und/oder die Simulationssoftware 33 kann Teil einer Koordinationssoftware 31 für den Zentralrechner 30 sein. Wenn der Zentralrechner 30 ein verteiltes Rechnersystem ist, kann das Betriebssystem 32 ein verteiltes Betriebssystem 32 sein. Außerdem kann es auch zweckmäßig sein, wenn die Koordinationssoftware 31 eine Simulationssoftware 33 umfasst, die die Echtzeitumgebungen der Steuergeräte 1i simuliert.

Die Steuergerätesoftware 3i läuft typischerweise unter dem Betriebssystem 32 für den Zentralrechner 30 oder unter der Simulationssoftware 33. Die einzelnen Funktionen (beispielsweise einzelne Fahrzeugbussysteme 4i und/oder einzelne Steuergerätefunktionen) können mittels Software simuliert werden oder mittels Hardwarekomponenten 1i realisiert werden, die über Datenschnittstellen 8i an den Zentralrechner 30 angeschlossen sind.

Besonders realitätsnahe Gesamttests sind möglich, wenn die Steuergerätesoftware 3i auf dem Zentralrechner 30 in Echtzeitgeschwindigkeit durchgeführt wird.

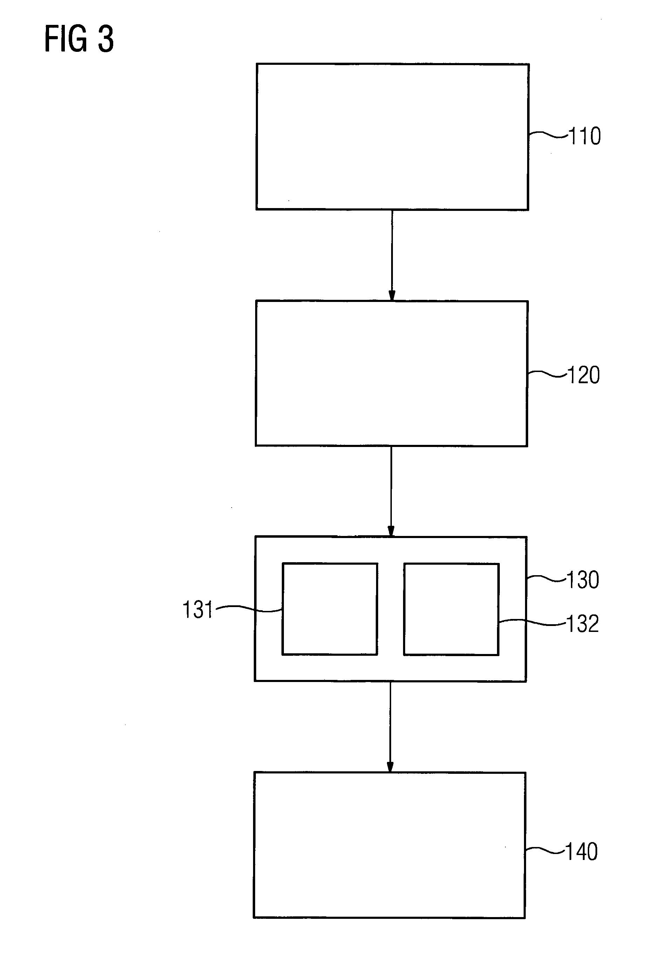

Das in FIG 3 gezeigte Verfahren 100 zum Durchführen von Gesamtfahrzeugtests umfasst folgende Schritte 110, 120, 131, 132, 140. In einem ersten Schritt 110 wird ein Zentralrechner 30 mit einer Koordinationssoftware 31 bereitgestellt. In einem zweiten Schritt 120 wird Steuergerätesoftware 3i einer Vielzahl von Steuergeräten 1i in den Zentralrechner 30 geladen. In einem dritten Schritt 130 wird die Steuergerätesoftware 3i der Vielzahl von Steuergeräten 2i unter der Koordinationssoftware 31 gleichzeitig oder quasigleichzeitig ausgeführt. Während der Ausführung 131 der Steuergerätesoftware 3i erfolgt ein Erfassen 132 von Testdaten. In einem vierten Schritt 140 werden die erfassten Testdaten ausgewertet.

Durch die Zentralarchitektur 30, 39 werden Unzulänglichkeiten von verteilten und meistens unsynchronisierten Anwendungen mit dazwischen liegenden Kommunikationsbussen 4i verringert oder vollständig eliminiert. Durch die höhere Deterministik sind Fehler schneller nachzustellen und zu finden. Die Variabilität des Systems in der Zeitachse wird durch die starke Verringerung der Anzahl unkoordiniert laufender Prozessoren und Betriebssysteme massiv verringert. Dies verbessert eine Reproduzierbarkeit deutlich.

Ähnlich wie beim heutigen SIL-Prüfstand kann in einem ersten Schritt der Rest des Fahrzeugs simuliert werden, welcher zum Test einer einzelnen Softwarefunktion notwendig ist.

Eine Verbesserung gegenüber den heute üblichen Testverfahren ergibt sich, wenn die Einzelfunktionen schrittweise fertiggestellt werden und diese nun miteinander getestet werden sollen. Bei fortschreitender Fertigstellung der Funktionen bei den einzelnen Zulieferern können diese nun ihre Softwarekomponenten untereinander austauschen (was mit Mitteln der IT-Technologie einfach ist) und auf ihren jeweiligen SIL-Prüfständen integrieren. Mit fortschreitender Integration kann die Fahrzeugsimulation schrittweise zurückgefahren. Es müssen keine Bussysteme mit nichtdeterministischem Verhalten aufwändig simuliert werden. Insbesondere steigt die Reproduzierbarkeit der Testergebnisse. Auch Testvektoren können leicht zwischen den Zulieferern ausgetauscht werden, um das Verhalten eigener und/oder beigestellter Komponenten ausführlicher zu testen.

Der Test kann bei jedem Zulieferer parallel zu Tests erfolgen, die bei anderen Zulieferern durchgeführt werden. Ein Austausch von Hardwarebaugruppen zwischen den Zulieferern kann in der Regel eingespart werden. Dadurch verkürzt sich die Reaktionszeit und der Aufwand für die Tests wird verringert.

Der Integrationsaufwand beim Fahrzeughersteller für das Gesamtsystem kann signifikant verringert werden, da nur noch eine Anbindung an die reale Hardware des Fahrzeugs erfolgen muss. Durch entsprechend standardisierte Schnittstellen zur Hardware kann auch hier der Aufwand und eine Fehlerquote verringert werden.

## Patentansprüche

1. Verfahren (100) zum Durchführen von Gesamtfahrzeugtests, wobei das Verfahren (100) folgende Schritte (110,120,131,132) umfasst:
- Bereitstellen (110) eines Zentralrechners (30) mit einer Koordinationssoftware (31), wobei der Zentralrechner (30) ein oder mehrere Fahrzeugbussysteme (4i) umfasst und der Zentralrechner (30) ein auf mindestens zwei Entwicklungsstandorte (51,52) verteiltes Rechnersystem ist und mindestens eines der Fahrzeugbussysteme (4i) des Zentralrechners (30) eine Datenverbindung (2i) zwischen den mindestens zwei Entwicklungsstandorten (51,52) nutzt;
- Laden (120) von Steuergerätesoftware (3i) einer Vielzahl von Steuergeräten (1i) in den Zentralrechner (30);
- gleichzeitiges oder quasigleichzeitiges Ausführen (131) der Steuergerätesoftware (3i) der Vielzahl von Steuergeräten (1i) unter der Koordinationssoftware (31) und Erfassen (132) von Testdaten, wobei die Koordinationssoftware (31) eine Simulationssoftware (33) umfasst, die Echtzeitumgebungen der Steuergeräte (1i) simuliert; und
- Auswerten (132) der Testdaten.

2. Verfahren (100) nach Anspruch 1, **dadurch ge- kennzeichnet,** dass der Zentralrechner (30) ein oder mehrere Entwicklungsrechner (6i) für die Steuergeräte (1i) umfasst.

3. Verfahren (100) nach Anspruch 1 oder 2, **dadurch gekennzeichnet , dass** die Koordinationssoftware (31) dazu vorbereitet ist, ein oder mehrere Fahrzeugbussysteme (4i) zu simulieren.

4. Verfahren (100) nach einem der Ansprüche 1 bis 3, **da- durch gekennzeichnet** , dass die Koordinationssoftware (31) ein Betriebssystem (32) für den Zentralrechner (30) umfasst.

5. Verfahren (100) nach Anspruch 1, **dadurch ge- kennzeichnet,** dass die Simulationssoftware (33) unter einem Betriebssystem (32) für den Zentralrechner (30) lauffähig ist.

6. Verfahren (100) nach einem der Ansprüche 1 bis 6, **da- durch gekennzeichnet** , dass die Steuergerätesoftware (3i) auf dem Zentralrechner (30) in Echtzeitgeschwindigkeit durchgeführt wird.

7. IT-System (70) zum Durchführen von Gesamtfahrzeugtests, **dadurch gekennzeichnet, dass** das IT-System (70) dazu vorbereitet ist, ein Verfahren (100) gemäß einem der Ansprüche 1 bis 7 durchzuführen.

## Claims

1. Method (100) for testing entire vehicles, wherein the method (100) comprises the following steps (110, 120, 131, 132) :
- Provision (110) of a central computer (30) with coordination software (31), wherein the central computer (30) comprises one or more vehicle bus systems (4i) and the central computer (30) is a computer system distributed across at least two development locations (51, 52) and at least one of the vehicle bus systems (4i) of the central computer (30) uses a data connection (2i) between the at least two development locations (51, 52);
- Loading (120) of control device software (3i) of a plurality of control devices (1i) into the central computer (30);
- Simultaneous or quasi-simultaneous execution (131) of the control device software (3i) of the plurality of control devices (1i) under the coordination software (31) and recording (132) of test data, wherein the coordination software (31) comprises simulation software (33) which simulates the realtime environments of the control devices (1i); and
- Evaluation (132) of the test data.

2. Method (100) according to claim 1,
**characterised in that** the central computer (30) comprises one or more development computers (6i) for the control devices (1i).

3. Method (100) according to claim 1 or 2,
**characterised in that** the coordination software (31) is initialised in order to simulate one or more vehicle bus systems (4i).

4. Method (100) according to one of claims 1 to 3,
**characterised in that** the coordination software (31) comprises an operating system (32) for the central computer (30).

5. Method (100) according to claim 1,
**characterised in that** the simulation software (33) can run under one operating system (32) for the central computer (30).

6. Method (100) according to one of claims 1 to 5,
**characterised in that** the control device software (3i) is executed on the central computer (30) at realtime speed.

7. IT system (70) for testing entire vehicles,
**characterised in that** the IT system (70) is initialised to execute a method (100) according to one of claims 1 to 7.

## Revendications

1. Procédé ( 100 ) pour effectuer un test complet de véhicule, dans lequel le procédé ( 100 ) comprend les stades ( 110, 120, 131, 132 ) suivantes :
- on se procure ( 110 ) un ordinateur ( 30 ) central ayant un logiciel ( 31 ) de coordination, l'ordinateur ( 30 ) central comprenant un ou plusieurs système ( s ) ( 4i ) de bus de véhicule et l'ordinateur ( 30 ) central étant un système d'ordinateur réparti sur au moins deux emplacements ( 51, 52 ) de développement et au moins l'un des systèmes ( 4i ) de bus de véhicule de l'ordinateur ( 30 ) central utilise une liaison ( 2i ) de données entre les au moins deux emplacements ( 51, 52 ) de développement ;
- on charge ( 120 ) des logiciels ( 3i ) d'appareils de commande d'une pluralité d'appareils ( 1i ) de commande dans l'ordinateur ( 30 ) central ;
- on exécute ( 131 ) simultanément ou quasi simultanément les logiciels ( 3i ) d'appareils de commande de la pluralité d'appareils ( 1i ) de commande sous le logiciel ( 31 ) de coordination et la détection ( 132 ) de données de test, le logiciel ( 31 ) de coordination comprenant un logiciel ( 33 ) de simulation, qui simule des environnements en temps réel des appareils ( 1i ) de commande et
- on exploite ( 132 ) les données de test.

2. Procédé ( 100 ) suivant la revendication 1, **caractérisé en ce que** l'ordinateur ( 30 ) central comprend un ou plusieurs ordinateurs ( 6i ) de développement pour les appareils ( 1i ) de commande.

3. Procédé ( 100 ) suivant la revendication 1 ou 2, **caractérisé en ce que** le logiciel ( 31 ) de coordination est préparé pour simuler un ou plusieurs système ( s ) ( 4i ) de bus de véhicule.

4. Procédé ( 100 ) suivant l'une des revendications 1 à 3, **caractérisé en ce que** le logiciel ( 31 ) de coordination comprend un système ( 32 ) pour faire fonctionner l'ordinateur ( 30 ) central.

5. Procédé ( 100 ) suivant la revendication 1, **caractérisé en ce que** le logiciel ( 33 ) de simulation peut être exploité sous un système ( 32 ) pour faire fonctionner l'ordinateur ( 30 ) central.

6. Procédé ( 100 ) suivant l'une des revendications 1 à 5, **caractérisé en ce que** le logiciel ( 3i ) d'appareils de commande est effectué sur l'ordinateur ( 30 ) central à vitesse en temps réel.

7. Système ( 70 ) IT pour effectuer des tests complets de véhicule, **caractérisé en ce que** le système ( 70 ) IT est préparé pour effectuer un procédé ( 100 ) suivant l'une des revendications 1 à 7.
